# EUROPÄISCHE PATENTSCHRIFT

(11) **EP 4 228 993 B1**
(45) Veröffentlichungstag und Bekanntmachung des Hinweises auf die Patenterteilung: **31.12.2025**
(21) Anmeldenummer: 21794797.7
(22) Anmeldetag: 15.10.2021
(51) Int. Cl.: B81C 1/00

(54) **VERFAHREN ZUR HERSTELLUNG EINER KRISTALLINEN SILIZIUMSCHICHT AUF EINEM SUBSTRAT MIT INTEGRIERTEN ELEKTRONISCHEN BAUELEMENTEN**
METHOD FOR PRODUCING A CRYSTALLINE SILICON LAYER ON A SUBSTRATE HAVING INTEGRATED ELECTRONIC COMPONENTS
PROCÉDÉ DE PRODUCTION D'UNE COUCHE DE SILICIUM CRISTALLIN SUR UN SUBSTRAT COMPORTANT DES COMPOSANTS ÉLECTRONIQUES INTÉGRÉS

(30) Priorität: 19.10.2020 DE 102020127431
(43) Veröffentlichungstag der Anmeldung: 23.08.2023
(73) Patentinhaber: Fraunhofer-Gesellschaft zur Förderung der angewandten Forschung e.V., 80686 München (DE)
(72) Erfinder: QUENZER, Hans-Joachim, 25524 Itzehoe (DE); KULKARNI, Amit, 25524 Itzehoe (DE); VEDDER, Christian, 52074 Aachen (DE); FUCHS, Florian, 52074 Aachen (DE); STOLLENWERK, Jochen, 52074 Aachen (DE)
(74) Vertreter: Gagel, Roland
(86) Internationale Anmeldenummer: PCT/EP2021/078604
(87) Internationale Veröffentlichungsnummer: WO 2022/084179

(56) Entgegenhaltungen:
- WO-A1-2020/204833
- DE-A1- 102015 208 519

## Beschreibung

### Technisches Anwendungsgebiet

Die vorliegende Erfindung betrifft ein Verfahren zur Herstellung einer kristallinen Siliziumschicht oder kristalliner Siliziumschichtbereiche auf einem Substrat mit integrierten elektronischen Bauelementen, insbesondere einem oder mehreren ASICs (Application-Specific Integrated Circuit). Bei den kristallinen Siliziumschichten und den kristallinen Siliziumschichtbereichen kann es sich sowohl um monokristalline als auch um polykristalline Schichten bzw. Schichtbereiche handeln.

Für die Herstellung monolithisch integrierter MEMS-Sensoren (MEMS: Micro-Electro-Mechanical Systems), wie z.B. Inertial- oder Thermopilesensoren, ist es erforderlich, auf einem bestehenden Auswerteschaltkreis in Form eines ASIC eine Schicht herzustellen, aus der die eigentliche MEMS-Sensorstruktur gefertigt wird. Dieses deponierte Schichtmaterial muss eine ganze Reihe technischer Anforderungen erfüllen. Zum einen müssen die Materialeigenschaften, wie die elektrische Leitfähigkeit, die mechanische und chemische Stabilität und nicht zuletzt der thermische Ausdehnungskoeffizient der Funktionalität des Sensors genügen. Den technischen Anforderungen stehen darüber hinaus wirtschaftliche Aspekte gegenüber. Für den wirtschaftlichen Erfolg eines neuen Herstellungsverfahrens ist die Akzeptanz in der Industrie besonders wichtig. Hierfür sind die Verfügbarkeit und die Kompatibilität des Schichtmaterials mit den bereits etablierten Mikrofabrikationsprozessen entscheidend.

Für die Herstellung von MEMS-Inertialsensoren wird gegenwärtig meist mono- oder polykristallines Silizium eingesetzt. Dieses Material ist in den Mikrofertigungsverfahren weit verbreitet und erfüllt die Anforderungen der Inertialsensoren nicht nur unter mechanischen, chemischen und elektrischen Gesichtspunkten. Entscheidender Vorteil von Poly-Silizium ist, dass es ein nahezu identisches thermomechanisches Verhalten aufweist wie das Silizium der Wafer, auf denen die Sensoren aufgebaut werden. Allerdings ist eine vertikale Integration von MEMS-Inertialsensoren aus Poly-Silizium auf ASICs aufgrund der hohen Prozesstemperaturen bei der Herstellung kristalliner Siliziumschichten von > 600°C nur in heterogenen Integrationsprozessen möglich, da ansonsten die thermische Belastungsgrenze der bestehenden Schaltkreise im Substrat, oberhalb der eine irreversible Veränderung der elektronischen Eigenschaften des ICs auftritt und die bei etwa 450°C liegt, deutlich überschritten wird. Eine vollständige Integration von MEMS-Silizium-Sensoren, d.h. eine monolithische Integration, auf fertigen ICs ist daher gegenwärtig nicht möglich.

### Stand der Technik

Eine Möglichkeit der Herstellung vertikal monolithisch integrierter MEMS-Sensoren besteht darin, das kristalline Silizium als Basismaterial des MEMS-Sensors durch andere Materialien zu substituieren, deren Abscheidetemperaturen unter 450°C liegen. Eine entsprechende Technik zur Herstellung von MEMS-Strukturen ist in der EP 3 155 667 B1 beschrieben, bei der das kristalline Silizium durch Metalle, Metalllegierungen oder leitfähige Metalloxide ersetzt wird, deren Abscheidetemperaturen unterhalb von 450°C liegen. Die zur Substitution von kristallinem Silizium eingesetzten Materialien sind u. a. Metalle, die mit Dünnschichtverfahren, wie etwa durch Sputtern aufgebracht werden, bspw. Aluminium, Kupfer oder Wolfram. Mehrschichtsysteme aus Metallen und bei niedrigen Temperaturen durch Plasmaprozesse (PECVD) abgeschiedene Oxide oder Nitride können ebenfalls zur Herstellung monolithischer MEMS-Sensoren eingesetzt werden. Weiterhin ist es bekannt, MEMS-Inertialsensoren aus einer Silizium-Germanium-Legierung (SiGe) aufzubauen.

Ein zentraler Nachteil der alternativen Materialsysteme besteht jedoch in der Diskrepanz der thermischen Ausdehnungskoeffizienten zwischen den alternativen Schichtmaterialien (z. B. Al, Cu, W, SiGe) und dem kristallinen Silizium als Substratmaterial für die integrierten Schaltkreise. Bei Änderungen der Umgebungstemperaturen im Sensorbetrieb führt dies zu thermisch induzierten Spannungen innerhalb des Sensorsystems wodurch die mechanischen Eigenschaften des Sensorsystems erheblich verändert werden können. Dies beeinträchtigt die Leistungsfähigkeit der Sensoren in ganz erheblichem Maße.

Aus J. Förster et al., "Excimer Laser Annealing of Amorphous Silicon-Germanium Layers for Above IC Processing", PRIME 2012, Aachen, Germany, Seiten 267 bis 270, ist ein Verfahren zur Erzeugung einer MEMS-Struktur über einem integrierten Schaltkreis beschrieben, bei dem eine amorphe Siliziumschicht bei Temperaturen unter 450°C auf dem Substrat mit dem integrierten Schaltkreis abgeschieden und anschließend mittels Laserstrahlung eines Excimer-Lasers durch kurzzeitiges Aufschmelzen kristallisiert wird. Die Dicke der abgeschiedenen amorphen Siliziumschicht liegt dabei bei maximal 1 µm. Durch die Bestrahlung mit der Excimer-Laserstrahlung konnte die amorphe Silizumschicht bis in eine Tiefe von etwa 200 - 250 nm kristallisiert werden. Allerdings ist diese Technik nicht für größere Schichtdicken geeignet und führt zu einer ungenügenden Oberflächenqualität der kristallisierten Schicht.

Das Patentdokument WO 2020/204833 A1 beschreibt ein ähnliches Verfahren zur Umwandlung einer amorphen Siliziumschicht in polykristallines Silizium durch Laserbehandlung zur Herstellung eines MEMS-Bauelements.

Die Aufgabe der vorliegenden Erfindung besteht darin, ein Verfahren zur Herstellung einer kristallinen Siliziumschicht oder kristalliner Siliziumschichtbereiche auf einem Substrat mit integrierten elektronischen Bauelementen anzugeben, das die Herstellung der kristallinen Schicht oder Schichtbereiche mit hoher Oberflächenqualität ohne Zerstörung der integrierten elektronischen Bauelemente ermöglicht und sich insbesondere für die Herstellung vertikal monolithisch integrierter MEMS-Sensoren eignet.

### Darstellung der Erfindung

Die Aufgabe wird mit dem Verfahren gemäß Patentanspruch 1 gelöst. Vorteilhafte Ausgestaltungen des Verfahrens sind Gegenstand der abhängigen Patentansprüche oder lassen sich der nachfolgenden Beschreibung sowie dem Ausführungsbeispiel entnehmen.

Bei dem vorgeschlagenen Verfahren wird eine vorzugsweise mit Dotierstoffen versetzte amorphe Siliziumschicht auf dem Substrat mit den integrierten elektronischen Bauelementen abgeschieden und durch Bestrahlung mit Laserstrahlung zumindest in einem oder mehreren Bereichen auf dem Substrat kristallisiert. Dadurch werden auch die vorzugsweise zugesetzten Dotierstoffe in der amorphen Siliziumschicht in das Kristallgefüge des kristallinen Siliziums eingebaut wodurch sich elektrische Leitfähigkeit gegenüber dem a-Si um mehrere Größenordnungen erhöht. Durch entsprechend lokale Bestrahlung können dabei eine oder mehrere kristalline Siliziumschichtbereiche erzeugt werden. Auch die gesamte amorphe Siliziumschicht kann selbstverständlich bei Bedarf durch die Bestrahlung kristallisiert werden. Das vorgeschlagene Verfahren zeichnet sich vor allem dadurch aus, dass die Bestrahlungsparameter der Bestrahlung mit der Laserstrahlung so gewählt werden, dass die amorphe Siliziumschicht durch Festphasenkristallisation kristallisiert, also nicht aufgeschmolzen wird. Bei einer Festphasenkristallisation wird die Schicht nur bis unterhalb des Schmelzpunktes aufgeheizt und für eine für die Kristallisation erforderliche Zeit auf der entsprechend erhöhten Temperatur gehalten. In dem Substrat, auf dem die amorphe Siliziumschicht abgeschieden wird und die kristalline Schicht oder kristallinen Schichtbereiche erzeugt werden, sind ein oder mehrere elektronische Bauteile oder Schaltkreise integriert. Hierbei kann es sich bspw. um ASICs handeln.

Mit dem vorgeschlagenen Verfahren können kristalline Schichten oder Schichtbereiche aus PolySilizium, insbesondere als MEMS-Strukturmaterial, auf einem Substrat, bspw. einem Wafer, mit einem oder mehreren integrierten Schaltkreisen hergestellt werden, ohne die Schaltkreise zu schädigen. Dies ermöglicht die Herstellung hochintegrierter Sensorsysteme, was auch die Herstellung mehrerer Sensoren auf einem CMOS-Schaltkreis einschließt. Bei Anwendung des Verfahrens zur Herstellung von MEMS-Sensoren sind außerdem aufgrund der miniaturisierten Verbindungsleitungen zwischen der MEMS-Struktur und dem CMOS-Schaltkreis die erreichbaren Empfindlichkeiten der Sensoren durch die Minimierung von Störeinflüssen (parasitäre Kapazitäten und Widerstände) deutlich gesteigert. Da keine Fügeverfahren zur Herstellung der MEMS-Strukturen erforderlich sind, reduziert sich die Komplexität des Herstellungsverfahrens gegenüber alternativen Verfahren deutlich.

Durch die Nutzung der Technik der Festphasenkristallisation erfolgt keine unerwünschte Oberflächenveränderung der Schicht, so dass anschließend auch keine Glättungsprozesse erforderlich sind. Die amorphe Siliziumschicht wird dabei durch die Laserstrahlung bis knapp unter den Schmelzpunkt kurz erhitzt, wobei die Wechselwirkungszeit so gewählt wird, dass die Kristallisation in der Schicht stattfindet. Die hierfür erforderlichen Parameter, insbesondere die Scangeschwindigkeit, die Intensität der Laserstrahlung sowie der Durchmesser des Laserstrahls auf der Schicht können vorab experimentell ermittelt werden.

Die Temperaturbelastung der integrierten Bauelemente bzw. des oder der integrierten Schaltkreise(s) bleibt bei der Schichtabscheidung der amorphen Siliziumschicht unterhalb der Grenze von 450°C, da sich eine derartige Schicht bei entsprechend geringeren Temperaturen abscheiden lässt. Bevorzugte Abscheidetechniken sind hierbei PECVD, Heißdraht-CVD, Magnetron-Sputtern oder ein anderes PVD-Verfahren. Besonders bevorzugt wird PECVD eingesetzt, da die damit erhaltenen Schichten später mit Siliziumtrockenätzprozessen bearbeitbar sind. Auch die Temperaturbelastung bei der anschließenden Laserbestrahlung erreicht nicht die für die elektronischen Bauelemente oder Schaltkreise kritische Grenze. Die Wechselwirkungszeit der Laserstrahlung bzw. des einen oder der mehreren eingesetzten Laserstrahlen mit der Schicht wird bei der Bestrahlung zeitlich begrenzt und liegt vorzugsweise im Bereich zwischen Nanosekunden und Sekunden, vorteilhaft bei weniger als 100 ms, besonders bevorzugt bei weniger als 10 ms. Diese zeitliche Begrenzung wird durch den Strahldurchmesser des Laserstrahls in Verbindung mit der Scangeschwindigkeit eingestellt. Der Laserstrahldurchmesser kann hierbei im Bereich zwischen µm und mm liegen. Durch diese scannende Bestrahlung wirkt der Teil des Substrates, der gerade nicht mit Laserstrahlung beaufschlagt wird, als Kühlkörper, spreizt die durch die Laserstrahlung eingetragene Wärmeleistung und führt die zugeführte Laserenergie aus dem mit Laserstrahlung beaufschlagten Bereich ab. Bei einer Abscheidung zusätzlicher Schichten, bspw. von Barriere- oder Opferschichten oder auch elektrischen Isolationsschichten vor der Abscheidung der amorphen Siliziumschicht wirken die Oxide und Nitride dieser Schichten aufgrund deren geringer Wärmeleitfähigkeit gegenüber dem Siliziumsubstrat zusätzlich als thermische Isolation, so dass der integrierte Schaltkreis dadurch zusätzlich gegenüber dem Wärmeeintrag geschützt ist. Die Dicke dieser Isolationsschichten, die in der Regel im Bereich zwischen nm und µm liegt, kann zum Teil auch den Erfordernissen hinsichtlich ihrer Isolationswirkung angepasst werden.

Bei der Kristallisation amorpher Siliziumschichten entstehen in Folge der Volumenkontraktion beim Phasenwechsel von amorph zu kristallin Zugspannungen in der abgeschiedenen Schicht. Diese können im Extremfall dazu führen, dass während der Kristallisation Risse entstehen oder das Schichtmaterial vom Substrat delaminiert. In einer bevorzugten Ausgestaltung des vorgeschlagenen Verfahrens wird dieser Gefahr dadurch entgegengewirkt, dass die Depositionsparameter bei der Abscheidung der amorphen Siliziumschicht so gewählt werden, dass diese Schicht unmittelbar nach der Abscheidung mit einer Druckspannung beaufschlagt ist. Durch diese Druckspannung, die den durch die Volumenkontraktion hervorgerufenen Zugspannungen entgegenwirkt und diese mindestens teilweise kompensiert, wird eine rissfreie Kristallisation der amorphen Siliziumschicht gewährleistet.

Die amorphe Siliziumschicht wird beim vorgeschlagenen Verfahren vorzugsweise mit einer Dicke von ≥ 1 µm, insbesondere zwischen 1 und 20 µm, auf dem Substrat abgeschieden. Derartig dicke Schichten sind vor allem für die bevorzugte Anwendung des vorgeschlagenen Verfahrens zur Erzeugung von MEMS-Strukturen erforderlich. Weiterhin erfolgt die Abscheidung vorzugsweise derart, dass die amorphe Siliziumschicht mit einer Dotierung abgeschieden wird, die die elektrische Leitfähigkeit der kristallinen Schicht oder Schichtbereiche erhöht. Eine derartige Abscheidung kann bspw. in einem geeigneten Reaktor unter Zuführung einer Mischung aus Silan und Phosphin erfolgen. Erst durch die Bestrahlung mit der Laserstrahlung werden dann die in der Schicht enthaltenen Dotierstoffe aktiviert und damit die elektrische Leitfähigkeit drastisch erhöht. Dies ist vor allem für die Anwendung zur Erzeugung von MEMS-Bauelementen erforderlich, um den elektrischen Schichtwiderstand der kristallinen Siliziumschicht auf ein geeignetes Maß zu reduzieren, vorzugsweise um mehrere Größenordnungen auf etwa 0,01 Ω*cm.

Bei der Laserkristallisation wird die Siliziumschicht kurzzeitig lokal erhitzt. Daraus resultiert ein räumlicher und zeitlicher Temperaturgradient innerhalb der Siliziumschicht. Dieser Temperaturgradient kann zum einen in Kombination mit der thermischen Ausdehnung des Schichtmaterials zu temporären Spannungsgradienten innerhalb der Siliziumschicht führen, die bei Überschreiten der Plastizitätsgrenze einen permanenten mechanischen Spannungsgradienten innerhalb der Siliziumschicht hervorrufen können. Zum anderen führt der Temperaturgradient zu unterschiedlichen Kristallisationsgraden innerhalb der Siliziumschicht, was sich ebenfalls in einem mechanischen Spannungsgradienten in der Schicht niederschlagen kann. Dieser Spannungsgradient führt aber bei der bevorzugten Anwendung des Verfahrens zur Erzeugung von MEMS-Strukturen nach dem Freistellen dieser Strukturen zu einer häufig unerwünschten Verbiegung der freitragenden Strukturen. Zur Reduzierung oder Vermeidung eines derartigen Spannungsgradienten wird die Wellenlänge der Laserstrahlung bei dem vorgeschlagenen Verfahren vorzugsweise derart gewählt, dass die optische Eindringtiefe dieser Strahlung in amorphes Silizium größer als die Schichtdicke der amorphen Siliziumschicht ist. Unter der optischen Eindringtiefe ist hierbei in bekannter Weise die Tiefe im Material zu verstehen, in der die Intensität der einfallenden Laserstrahlung auf 1/e abgefallen ist. Durch diese Wahl der Wellenlänge wird der durch die Laserbestrahlung erzeugte Temperaturgradient in der Siliziumschicht reduziert. Dadurch wird die Energie im Gegensatz zu Laserstrahlung, die nur in oberflächennahen Bereichen absorbiert wird, auch in tiefere Bereiche der Siliziumschicht eingetragen, was schließlich zu einer Reduzierung des Temperaturgradienten führt. Vorzugsweise wird hierfür Laserstrahlung im infraroten Spektralbereich, besonderes bevorzugt im nahen Infrarot verwendet.

In einer vorteilhaften Ausgestaltung des vorgeschlagenen Verfahrens werden die obigen Spannungsgradienten in der Schicht gezielt ausgenutzt, um bei Erzeugung einer MEMS-Struktur eine beabsichtigte Verbiegung der Struktur zu erhalten. Hierzu werden wenigstens zwei kristalline Siliziumschichten in der oben beschriebenen Art und Weise übereinander erzeugt, die unterschiedliche Spannungen und/oder Spannungsgradienten aufweisen. Dies kann über eine unterschiedliche Dicke der Schichten bei ansonsten gleichen Bestrahlungsparametern oder auch über die Wahl unterschiedlicher Bestrahlungsparameter für zwei Schichten identischer Dicke - oder auch durch eine Kombination beider Maßnahmen - erreicht werden. Die erste (unterste) Schicht wird dabei zunächst als amorphe Siliziumschicht auf dem Substrat abgeschieden und durch die Laserbestrahlung kristallisiert, bevor die zweite Schicht als amorphe Siliziumschicht auf der bereits kristallisierten Schicht abgeschieden und dann wiederum durch Laserbestrahlung kristallisiert wird.

Die charakteristischen optischen Eigenschaften von amorphem Silizium hängen auch von der Temperatur der Siliziumschicht ab. Durch zusätzliches Vorheizen, bspw. mittels einer Heizplatte, kann können Temperaturgradienten bei der Bestrahlung der Schicht weiter reduziert werden. Durch das Vorheizen wird das Gesamttemperaturniveau innerhalb des Schichtsystems angeheben und damit Temperaturgradienten verringert, wobei natürlich auch hier die maximale Temperaturbelastung des integrierten Schaltkreises nicht überschritten werden darf. Auch die optische Eindringtiefe der Laserstrahlung hängt von der Temperatur der Siliziumschicht ab und kann dann über die Wahl einer geeigneten Laserwellenlänge für das jeweilige Temperaturniveau optimiert werden.

In einer vorteilhaften Ausgestaltung wird die Vorheizung nicht mit einer Heizplatte sondern mit Hilfe eines zweiten Laserstahls durchgeführt, der die amorphe Siliziumschicht lokal vor der Rekristallisation mit dem anderen Laserstrahl vorheizt. Aufgrund dieser nur lokalen Vorheizung sinkt die Temperaturbelastung des integrierten Schaltkreises gegenüber einer vollflächigen Aufheizung. Der zur Vorwärmung eingesetzte zweite Laserstrahl kann dabei in Scanrichtung unmittelbar vor oder auch koaxial zu dem Laserstrahl eingesetzt werden, durch den die Kristallisation erfolgt. Der zweite Laserstrahl zum lokalen Vorheizen kann bspw. eine andere Wellenlänge als der für die Kristallisation eingesetzte Laserstrahl aufweisen, bspw. eine Wellenlänge im sichtbaren Spektralbereich, und auch einen größeren Laserstrahldurchmesser. Für die Kristallisation und auch das Aufheizen wird vorzugsweise kontinuierliche Laserstrahlung (cw-Laserstrahlung) eingesetzt.

Der Temperaturgradient in der Siliziumschicht kann auch dadurch reduziert werden, dass die gewünschte kristalline Siliziumschicht aus mehreren dünneren kristallinen Siliziumschichten nacheinander aufgebaut wird. Hierbei wird mehrfach in zeitlicher Abfolge jeweils eine dünnere amorphe Siliziumschicht abgeschieden und mit dem vorgeschlagen Verfahren kristallisiert. Die nächste Schicht wird dabei immer auf der bereits kristallisierten Siliziumschicht abgeschieden, wie dies bereits weiter oben in Zusammenhang mit der Erzeugung von wenigstens zwei kristallinen Siliziumschichten übereinander erläutert wurde.

Zur Herstellung vertikal monolithisch integrierter MEMS-Bauelemente, der bevorzugten Anwendung des vorgeschlagenen Verfahrens, werden vor der Abscheidung der amorphen Siliziumschicht in bekannter Weise noch eine oder mehrere ätzresistente Barriereschichten und eine oder mehrere Opferschichten auf das Substrat aufgebracht, durch die die nachfolgende Freilegung der MEMS-Strukturen ermöglicht wird. Nach der Festphasenkristallisation der entsprechenden Bereiche der Siliziumschicht werden dann die Opferschichten in bekannter Weise zumindest teilweise entfernt, in der Regel durch ein Trockenätzverfahren oder Gasphasenätzen, um dadurch die gewünschten freistehenden Strukturen aus der kristallinen Siliziumschicht oder den kristallinen Schichtbereichen zu erzeugen.

Durch die beim vorgeschlagenen Verfahren genutzte Kristallisation der Siliziumschichten in der festen Phase (Festphasenkristallisation), also ohne ein Aufschmelzen des Schichtmaterials, werden zusätzliche Vorteile erzielt. So kann gegenüber einer Kristallisation durch Aufschmelzen eine Entnetzung der Siliziumschmelze genauso vermieden werden wie potenzielle Materialumverteilungen durch Schmelzbadströmungen. Die Oberflächenmorphologie bleibt nahezu unverändert, womit keine zusätzlichen Planarisierungsprozesse für die Weiterprozessierung der kristallisierten Siliziumschicht notwendig werden.

Das vorgeschlagene Verfahren lässt sich für alle Anwendungen einsetzen, bei denen eine kristalline Siliziumschicht über integrierten elektronischen Bauelementen oder Schaltkreisen erzeugt werden soll. Dies schließt insbesondere eine Vielzahl von MEMS-Bauelementen ein, bspw. Inertialsensoren wie etwa Beschleunigungs-, Drehraten- oder mechanische Magnetfeldsensoren aber auch Infrarotsensoren auf der Basis des Seebeck-Effekts (Thermosäule) oder der Widerstandsänderungen von Poly-Silizium (Bolometer). Außerdem eignet sich das Verfahren auch zum Aufbau präziser Resonatoren als Zeitnormale (Ersatz für Schwingquarze) und für den Aufbau von miniaturisierten Aktuatorarrays, wie z.B. Spiegelarrays als Flächenlichtmodulatoren (DMD).

### Kurze Beschreibung der Zeichnungen

Das vorgeschlagene Verfahren wird nachfolgend anhand von Ausführungsbeispielen in Verbindung mit den Zeichnungen nochmals näher erläutert. Hierbei zeigen:

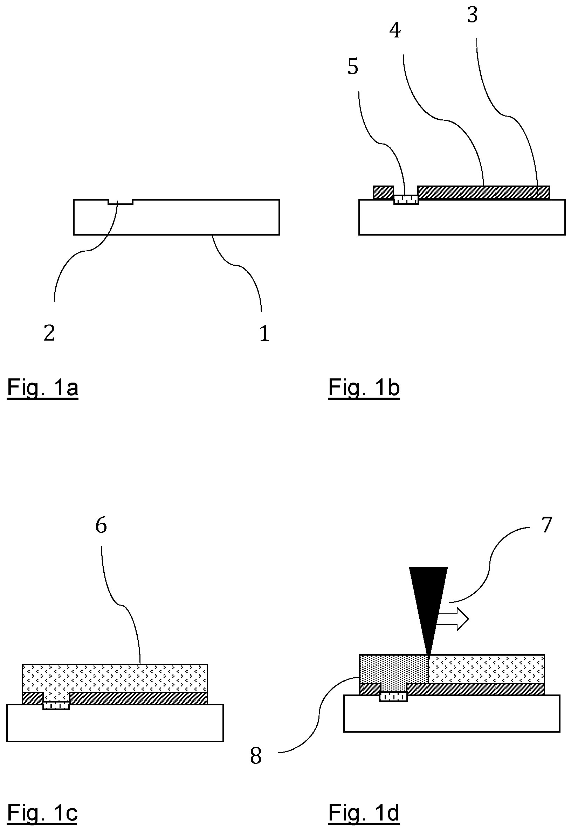

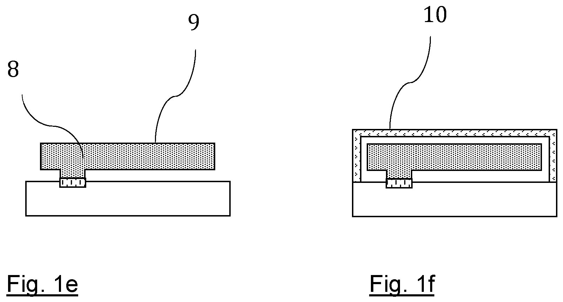

- Fig. 1a-f: verschiedene Prozessierungsschritte zur Herstellung einer MEMS-Struktur auf einem ASIC unter Einsatz des vorgeschlagenen Verfahrens.

### Wege zur Ausführung der Erfindung

Im Folgenden werden der Aufbau und die Herstellung eines IC-kompatiblen MEMS Inertialsensors aus Polysilizium kurz skizziert. Der MEMS-Sensor aus polykristallinem Silizium wird direkt auf den obersten Isolationsschichten des zum Betrieb des Sensors ausgebildeten ASIC (Applikationsspezifischer integrierte Schaltung), meist einem CMOS-Schaltkreis, hergestellt. Figur 1a zeigt hierzu ein Substrat 1, in dem der ASIC integriert ist. An der Oberfläche des Substrates 1 ist eine Kontaktöffnung 2 ausgebildet, die der späteren elektrischen Kontaktierung der freitragenden MEMS-Struktur mit dem CMOS-Schaltkreis dient. Für die Herstellung des Sensors werden zunächst ätzresistente Barriereschichten 3, bspw. aus Al₂O₃, und anschließend Opferschichten 4, bspw. aus SiO₂, auf das Substrat aufgebracht. Diese Schichten werden strukturiert und dabei in diesem Beispiel auch Kontaktlöcher zur Metallisierung des CMOS-Schaltkreises hergestellt, die anschließend mit temperaturbeständigen Metallen verfüllt werden. Figur 1b zeigt beispielhaft Barriere- und Opferschichten 3, 4 sowie eine Metallisierung in dem entsprechenden Kontaktloch 2. Die Barriere- und Opferschichten sind so gestaltet, dass sie eine geeignete thermische Isolationswirkung zum CMOS-Schaltkreis erzielen.

Auf dieser Basis wird im vorliegenden Beispiel eine 1 bis 20 µm Dicke, dotierte amorphe Siliziumschicht 6 mittels eines PECVD-Prozesses aufgebracht, wie dies in Figur 1c angedeutet ist. Die Abscheidetemperatur liegt dabei mit ≤ 450°C innerhalb des tolerierbaren Temperaturbereichs des CMOS-Schaltkreises. Die Abscheidung dieser amorphen Siliziumschicht erfolgt dabei vorzugsweise derart, dass diese Schicht mit einer Druckspannung beaufschlagt ist, wie dies bereits weiter oben erläutert wurde.

Zur Erzeugung einer geeigneten Druckspannung können die Parameter bei der Abscheidung der Schicht mit einem PECVD-Prozess in der folgenden Weise gewählt werden:
- Prozesstemperatur:
   T = 400°C
- Leistung und Anregungsfrequenz für die Plasmaerzeugung:
   P = 500 W
   f1 = 13,6 MHz
   f2 = 15 kHZ
- Gasflüsse:
   SiH4 (in H2 gemischt): 600 sccm
   PH3 (in H2 gemischt): 400 sccm
   Trägergas (Argon): 4000 sccm
   P = 3.5 mbar

Anschließend wird die amorphe Siliziumschicht 6 mittels Laserstrahlung kristallisiert und die dabei enthaltenen Dotierstoffe aktiviert. Dies ist erforderlich, um den Schichtwiderstand auf etwa 0,01 Ω*cm abzusenken und damit eine elektrische Verbindung der späteren MEMS-Struktur mit dem CMOS-Schaltkreis zu ermöglichen. Figur 1d zeigt hierzu den über die amorphe Siliziumschicht 6 geführten Laserstrahl 7 und die dadurch kristallisierte Siliziumschicht 8.

Zur Festphasenkristallisation einer amorphen Siliziumschicht einer Dicke von 10 µm über einer 2,5 µm dicken Opferschicht wurden im vorliegenden Beispiel folgende Bestrahlungsparameter gewählt:
- Wellenlänge des Laserstrahls: λ= 1070nm
- Laserstrahlintensität 11,4 kW/cm²
- Wechselwirkungszeit t_{ww} = 3,3ms
Der Laserstrahl 7 wurde dabei in Luftatmosphäre scannend entlang einer mäanderförmigen Bahn mit einem Spurabstand von 60 µm über die amorphe Siliziumschicht geführt. Die Siliziumschicht wurde vor der Bestrahlung auf eine Temperatur von 300°C vorgeheizt.

Nach der Erzeugung der kristallinen Siliziumschicht 8 werden die Opferschichten durch Trockenätzen oder Gasphasenätzen weggeätzt, um die gewünschte MEMS-Struktur 9 freizustellen, wie dies in der Figur 1e angedeutet ist. Im letzten Schritt erfolgt dann die Verkapselung 10 der fertig gestellten MEMS-Struktur.

### Bezugszeichenliste

- 1: Substrat mit ASIC
- 2: Kontaktöffnung
- 3: Barriereschicht
- 4: Opferschicht
- 5: Metallisierung
- 6: amorphe Siliziumschicht
- 7: Laserstrahl
- 8: kristallisierte Siliziumschicht
- 9: MEMS-Struktur
- 10: Verkapselung

## Patentansprüche

1. Verfahren zur Herstellung wenigstens einer kristallinen Siliziumschicht oder kristalliner Siliziumschichtbereiche auf einem Substrat (1) mit integrierten elektronischen Bauelementen, insbesondere einem oder mehreren ASICs, bei dem
- eine amorphe Siliziumschicht (6) auf dem Substrat (1) abgeschieden und durch Bestrahlung mit Laserstrahlung zumindest in einem oder mehreren Bereichen auf dem Substrat (1) kristallisiert wird,
**dadurch gekennzeichnet,dass**
- die amorphe Siliziumschicht eine Dicke von ≥ 1µm hat, und
- wobei Bestrahlungsparameter der Bestrahlung mit Laserstrahlung so gewählt werden, dass die amorphe Siliziumschicht (6) durch Festphasenkristallisation kristallisiert.

2. Verfahren nach Anspruch 1,
**dadurch gekennzeichnet,**
**dass** Abscheideparameter bei der Abscheidung der amorphen Siliziumschicht (6) so gewählt werden, dass die abgeschiedene amorphe Siliziumschicht (6) eine Druckspannung aufweist, durch die eine bei der anschließenden Festphasenkristallisation auftretende Zugspannung in der kristallisierten Siliziumschicht (8) zumindest teilweise kompensiert wird.

3. Verfahren nach Anspruch 1 oder 2,
**dadurch gekennzeichnet,**
**dass** wenigstens zwei der kristallinen Siliziumschichten oder kristallinen Siliziumschichtbereiche in zeitlicher Abfolge übereinander auf dem Substrat (1) erzeugt werden.

4. Verfahren nach Anspruch 3,
**dadurch gekennzeichnet,**
**dass** die wenigstens zwei kristallinen Siliziumschichten oder kristallinen Siliziumschichtbereiche mit unterschiedlicher Dicke und/oder mit unterschiedlichen Bestrahlungsparametern bei der Festphasenkristallisation erzeugt werden.

5. Verfahren nach einem der Ansprüche 1 bis 4,
**dadurch gekennzeichnet,**
**dass** die Bestrahlung mit Laserstrahlung durch Abscannen der amorphen Siliziumschicht (6) mit wenigstens einem Laserstrahl (7) erfolgt.

6. Verfahren nach Anspruch 5,
**dadurch gekennzeichnet,**
**dass** eine Wechselwirkungszeit des Laserstrahls (7) mit der amorphen Siliziumschicht (6) über eine Wahl von Scangeschwindigkeit und Strahldurchmesser des Laserstrahls (7) auf der amorphen Siliziumschicht (6) so eingestellt wird, dass eine Temperaturbelastung der integrierten elektronischen Bauelemente unterhalb einer thermischen Belastungsgrenze dieser Bauelemente liegt.

7. Verfahren nach einem der Ansprüche 1 bis 6,
**dadurch gekennzeichnet,**
**dass** die amorphe Siliziumschicht (6) vor der Bestrahlung mit Laserstrahlung vorgeheizt wird.

8. Verfahren nach Anspruch 5 oder 6,
**dadurch gekennzeichnet,**
**dass** die amorphe Siliziumschicht (6) vor der Bestrahlung mit dem wenigstens einen Laserstrahl (7) jeweils lokal mit einem weiteren Laserstrahl vorgeheizt wird.

9. Verfahren nach einem der Ansprüche 1 bis 8,
**dadurch gekennzeichnet,**
**dass** die amorphe Siliziumschicht (6) mit einer Dicke zwischen 1 und 20 µm auf dem Substrat abgeschieden wird.

10. Verfahren nach einem der Ansprüche 1 bis 9,
**dadurch gekennzeichnet,**
**dass** die amorphe Siliziumschicht (6) mit zusätzlichen Dotierstoffen versetzt wird, so dass die elektrische Leitfähigkeit der daraus erzeugten kristallinen Siliziumschicht (8) oder Siliziumschichtbereiche erhöht wird.

11. Verfahren nach einem der Ansprüche 1 bis 10,
**dadurch gekennzeichnet,**
**dass** die Bestrahlung mit Laserstrahlung einer Wellenlänge erfolgt, bei der eine Eindringtiefe der Laserstrahlung in amorphem Silizium wenigstens der Dicke der amorphen Siliziumschicht (6) entspricht.

12. Verfahren nach einem der Ansprüche 1 bis 11,
**dadurch gekennzeichnet,**
**dass** Bestrahlung mit Laserstrahlung im infraroten Spektralbereich erfolgt.

13. Verfahren nach einem der Ansprüche 1 bis 12 zur Herstellung vertikal monolithisch integrierter MEMS-Bauelemente, bei dem vor der Abscheidung der amorphen Siliziumschicht (6) eine oder mehrere ätzresistente Barriereschichten (3) und eine oder mehrere Opferschichten (4) auf das Substrat (1) aufgebracht und nach der Festphasenkristallisation durch zumindest teilweise Entfernung der Opferschichten (4) eine oder mehrere freistehende Strukturen (9) aus der kristallinen Siliziumschicht (8) oder den kristallinen Siliziumschichtbereichen erzeugt werden.

## Claims

1. Method for producing at least one crystalline silicon layer or crystalline silicon layer region on a substrate (1) having integrated electronic components, in particular one or more ASICs in which
- an amorphous silicon layer (6) is deposited on the substrate (1) and crystallised on the substrate (1) in at least one or more regions by means of irradiation with laser radiation,
**characterized in that**
- the amorphous silicon layer has a thickness of ≥ 1 µm,
- wherein irradiation parameters of the irradiation with laser radiation are selected such that the amorphous silicon layer (6) crystallises by means of solid phase crystallisation.

2. Method according to Claim 1,
**characterized in that**
the deposit parameters for depositing the amorphous silicon layer (6) are selected such that the deposited amorphous silicon layer (6) has a compressive stress which at least partially compensates for a tensile stress occurring in the crystallised silicon layer (8) during the subsequent solid phase crystallisation.

3. Method according to Claim 1 or 2,
**characterized in that**
at least two of the crystalline silicon layers or crystalline silicon layer regions are created one on top of the other on the substrate (1) in temporal sequence.

4. Method according to Claim 3,
**characterized in that**
the at least two crystalline silicon layers or crystalline silicon layer regions are created with different thickness and/or with different irradiation parameters during the solid phase crystallisation.

5. Method according to any one of Claims 1 to 4,
**characterized in that**
the irradiation with laser radiation is performed by scanning of the amorphous silicon layer (6) with at least one laser beam (7).

6. Method according to Claim 5,
**characterized in that**
an interaction time of the laser beam (7) with the amorphous silicon layer (6) is adjusted by selection of a scanning speed and beam diameter of the laser beam (7) on the amorphous silicon layer (6) in such manner that a thermal load on the integrated electronic components is below a thermal load limit for these components.

7. Method according to any one of Claims 1 to 6,
**characterized in that**
the amorphous silicon layer (6) is preheated before the irradiation with laser radiation.

8. Method according to Claim 5 or 6,
**characterized in that**
the amorphous silicon layer (6) is preheated locally with a further laser beam in each case before the irradiation with the at least one laser beam (7).

9. Method according to any one of Claims 1 to 8,
**characterized in that**
the amorphous silicon layer (6) is deposited on the substrate with a thickness between 1 and 20 µm.

10. Method according to any one of Claims 1 to 9,
**characterized in that**
the amorphous silicon layer (6) is mixed with additional dopants, so that the electrical conductivity of the crystalline silicon layer (8) or silicon layer regions created therefrom is increased.

11. Method according to any one of Claims 1 to 10,
**characterized in that**
the irradiation takes place with laser radiation of a wavelength at which a penetration depth of the laser radiation in amorphous silicon is at least equivalent to the thickness of the amorphous silicon layer (6).

12. Method according to any one of Claims 1 to 11,
**characterized in that**
irradiation with laser radiation takes place in the infrared spectral range.

13. Method according to any one of Claims 1 to 12 for the production of vertically monolithically integrated MEMS components, in which one or more corrosion-resistant barrier layers (3) and one or more sacrificial layers (4) are applied to the substrate (1) before the deposition of the amorphous silicon layer (6), and one or more free-standing structures (9) are created from the crystalline silicon layer (8) or the crystalline silicon layer regions by at least partial removal of the sacrificial layers (4) after the solid phase crystallisation.

## Revendications

1. Procédé de production d'au moins une couche de silicium cristallin ou de zones de couche de silicium cristallin sur un substrat (1) intégrant des composants électroniques, notamment un ou plusieurs ASIC, dans lequel
- une couche de silicium amorphe (6) est déposée sur le substrat (1) et cristallisée par irradiation laser dans au moins une ou plusieurs zones sur le substrat (1),
**caractérisé en ce que**
- la couche de silicium amorphe a une épaisseur de ≥ 1 µm et
- dans lequel les paramètres d'irradiation de l'irradiation avec un rayonnement laser sont choisis de telle sorte que la couche de silicium amorphe (6) cristallise par cristallisation en phase solide.

2. Procédé selon la revendication 1, **caractérisé en ce que** les paramètres de dépôt de la couche de silicium amorphe (6) sont choisis de telle sorte que la couche de silicium amorphe déposée (6) présente une contrainte de compression, qui compense au moins partiellement la contrainte de traction survenant dans la couche de silicium cristallisé (8) lors de la cristallisation en phase solide ultérieure.

3. Procédé selon la revendication 1 ou 2, **caractérisé en ce que** au moins deux des couches de silicium cristallin ou des zones de silicium cristallin sont produites l'une au-dessus de l'autre sur le substrat (1) dans un ordre chronologique.

4. Procédé selon la revendication 3, **caractérisé en ce que** les au moins deux couches de silicium cristallin ou zones de silicium cristallin sont produites avec des épaisseurs différentes et/ou des paramètres d'irradiation différents lors de la cristallisation en phase solide.

5. Procédé selon une des revendications 1 à 4, **caractérisé en ce que** l'irradiation par rayonnement laser s'effectue par balayage de la couche de silicium amorphe (6) avec au moins un faisceau laser (7).

6. Procédé selon la revendication 5, **caractérisé en ce qu'**un temps d'interaction du faisceau laser (7) avec la couche de silicium amorphe (6) est ajusté en sélectionnant la vitesse de balayage et le diamètre du faisceau laser (7) sur la couche de silicium amorphe (6) de telle sorte que la charge thermique des composants électroniques intégrés soit inférieure à la limite de charge thermique de ces composants.

7. Procédé selon une des revendications 1 à 6, **caractérisé en ce que** la couche de silicium amorphe (6) est préchauffée avant l'irradiation par rayonnement laser.

8. Procédé selon la revendication 5 ou 6, **caractérisé en ce que** la couche de silicium amorphe (6) est préchauffée localement avec un autre faisceau laser avant l'irradiation avec le ou les faisceaux laser (7).

9. Procédé selon une des revendications 1 à 8, **caractérisé en ce que** la couche de silicium amorphe (6) est déposée sur le substrat avec une épaisseur comprise entre 1 et 20 µm.

10. Procédé selon une des revendications 1 à 9, **caractérisé en ce que** la couche de silicium amorphe (6) est mélangée à des dopants supplémentaires, de sorte que la conductivité électrique de la couche de silicium cristallin (8) ou des zones de silicium produites à partir de celle-ci est augmentée.

11. Procédé selon une des revendications 1 à 10, **caractérisé en ce que** l'irradiation est réalisée avec un rayonnement laser d'une longueur d'onde à laquelle la profondeur de pénétration du rayonnement laser dans le silicium amorphe correspond à au l'épaisseur de la couche de silicium amorphe (6).

12. Procédé selon une des revendications 1 à 11, **caractérisé en ce que** l'irradiation est réalisée avec un rayonnement laser dans le domaine spectral infrarouge.

13. Procédé selon une des revendications 1 à 12, pour la production de composants MEMS intégrés verticalement de manière monolithique, dans lequel, avant le dépôt de la couche de silicium amorphe (6), une ou plusieurs couches barrières résistantes à la gravure (3) et une ou plusieurs couches sacrificielles (4) sont appliquées sur le substrat (1), et après la cristallisation en phase solide, une ou plusieurs structures autoporteuses (9) sont créées à partir de la couche de silicium cristallin (8) ou des zones de couche de silicium cristallin par élimination au moins partielle des couches sacrificielles (4).
